# EUROPÄISCHE PATENTSCHRIFT

(11) **EP 1 297 349 B1**
(45) Veröffentlichungstag und Bekanntmachung des Hinweises auf die Patenterteilung: **30.11.2005**
(21) Anmeldenummer: 01953830.5
(22) Anmeldetag: 29.06.2001
(51) Int. Cl.: G01R 33/07, H03H 11/12

(54) **VERSTÄRKERSCHALTUNG MIT OFFSETKOMPENSATION**
AMPLIFIER CIRCUIT WITH OFFSET COMPENSATION
CIRCUIT AMPLIFICATEUR AVEC COMPENSATION DU DECALAGE

(30) Priorität: 05.07.2000 DE 10032530
(43) Veröffentlichungstag der Anmeldung: 02.04.2003
(73) Patentinhaber: Infineon Technologies AG, 81669 München (DE)
(72) Erfinder: MOTZ, Mario, A-9241 Wernberg (AT)
(74) Vertreter: Epping - Hermann - Fischer
(86) Internationale Anmeldenummer: PCT/DE2001/002438
(87) Internationale Veröffentlichungsnummer: WO 2002/003087

(56) Entgegenhaltungen:
- GB-A- 2 019 146
- US-A- 5 621 319

## Beschreibung

Die Erfindung betrifft eine Verstärkerschaltung mit Offsetkompensation, insbesondere für gechoppt betriebene Magnetfeldsensoren.

Sensoren, beispielsweise Magnetfeldsensoren, benötigen zum präzisen Arbeiten üblicherweise eine Offsetfehlerkorrektur. Bei als Magnetfeldsensoren arbeitenden integrierten Hall-Elementen kann ein Offset-Fehler beispielsweise durch ein fertigungsbedingtes Verbiegen des Silizium-Plättchens (mechanical stress) oder durch Litographie-Ungenauigkeiten beim Herstellungsprozeß entstehen. Weitere Offset-Fehler können durch die äußere Beschaltung des Hall-Sensors, beispielsweise durch Offsetspannungen in dem Hall-Sensor nachgeschalteten Verstärkern, bedingt sein.

In dem Dokument US 5,621,319 ist ein Verfahren zur Kompensation der bei Hall-Sensoren üblicherweise auftretenden Offsetspannung angegeben. Dabei sind am Hall-Sensor zwei orthogonal zueinander angeordnete Klemmenpaare vorgesehen, wobei jeweils einem Klemmenpaar der Erregerstrom zugeführt wird, und am anderen Klemmenpaar die Hall-Spannung zur Verfügung steht. Im Chopping-Takt wird zwischen den Klemmenpaaren umgeschaltet. Hierdurch wird das Wechselspannungsfehlersignal verringert.

Dokument US 3,807,919 betrifft eine Null-schleife zur Korrektur von Fehlersignalen mit geringen Frequenz in Hochleistungsverstärkern.

Eine Weiterbildung dieses Chopped-Hall-Prinzips zu einem Hall-Sensor mit N Anschlußklemmenpaaren, welche zyklisch vertauscht werden, wobei die Hall-Spannung jeweils an einem Klemmenpaar abgreifbar ist, welches orthogonal zum Klemmenpaar des Erregerstroms angeordnet ist, ist in dem Dokument "Spinning-Current Method for Offset Reduction in Silicon Hall Plates" von Peter Jahn Adriaan Munter, Delft University Press, 1992, Seite 12 angegeben.

Den beschriebenen Offset-Kompensationsverfahren für Magnetfeldsensoren ist der Nachteil gemeinsam, daß im dem Magnetfeldsensor nachgeschalteten Verstärker sowohl das Nutzsignal als auch das gechoppte Fehlersignal für eine Weiterverarbeitung beziehungsweise Demodulation hochverstärkt werden müssen. Dies erfordert eine hohe Aussteuerbarkeit der Verstärkerstufen, welche der Forderung nach immer kleinerer interner Betriebsspannung entgegensteht. Zur genügenden Unterdrückung des Wechselspannungsfehlersignals sind umfangreiche Schaltungsmaßnahmen erforderlich.

Weiterhin führt das beschriebene Sampeln des Nutzsignals dann zu einem zusätzlichen Fehler, wenn sich das Nutzsignal ändert. Dieses Fehlersignal muß bei zeitkritischen Anwendungen zusätzlich aus dem Nutzsignal herausgefiltert werden.

Weitere Nachteile der beschriebenen Offset-Kompensationsverfahren liegen zum einen darin, daß aufgrund von in den Sample-and-Hold-Schaltungen verwendeten, offsetbehafteten Pufferverstärkern zusätzliche, unerwünschte Offsets entstehen und zum anderen weitere Offsets durch die Verwendung von Summationswiderständen, welche Mismatches (Fehlanpassungen) aufweisen, entstehen. Diese Offsets werden gemäß des Chopped-Hall-Prinzips zwar verringert, aber nicht vollständig beseitigt.

Aufgabe der vorliegenden Erfindung ist es, eine Verstärkerschaltung mit Offsetkompensation anzugeben, welche für gechoppt betriebene Hall-Sensoren geeignet ist, einen geringen Aussteuerbereich erfordert und einen geringen Filteraufwand zur Unterdrückung von Wechselspannungsfehlersignalen benötigt.

Erfindungsgemäß wird die Aufgabe durch eine Verstärkerschaltung mit Offsetkompensation gelöst, gemäß Anspruch 1.

Gemäß dem Prinzip der vorliegenden Erfindung wird die Offsetkomponente des ersten und zweiten Meßsignals jeweils mit einem Fehlersignal-Demodulator aus den Meßsignalen ausgekoppelt, das Fehlersignal wird demoduliert und anschließend wird das demodulierte Fehlersignal auf den Eingang des Verstärkers gegengekoppelt. Hierdurch wird das Fehlersignal beziehungsweise die Offsetkomponente der Meßsignale bereits am Verstärkereingang eliminiert, so daß der Aussteuerungsbereich des Verstärkers nurmehr der Nutzkomponente der Meßsignale anzupassen ist. Folglich kann der Aussteuerbereich des Verstärkers deutlich reduziert werden. Es ergibt sich somit eine Ersparnis von Chipfläche bei höherer Genauigkeit der Schaltung. Zudem ergibt sich insgesamt eine geringere, nur durch die Verstärkerschaltung bedingte Verzögerungszeit (Delay). Weiterhin werden Fehlersignale, welche durch Veränderung des Nutzsignals bedingt sind, durch die Vermeidung einer Sampling-Verarbeitung im Hauptsignalzweig vermieden.

Nach einem Einschalten der Verstärkerschaltung werden zunächst sowohl Nutzkomponente als auch Offsetkomponente der Meßsignale sowie Verstärkeroffsetsignale im Verstärker verstärkt. Bereits nach wenigen Taktzyklen führt die Fehlersignal-Gegenkopplung dazu, daß ohne Verfälschung der Nutzkomponenten die Offsetkomponenten stark reduziert sind.

In der Fehlersignalgegenkopplung kann ein Integrator vorgesehen sein, wodurch Offsets nahezu vollständig beseitigt werden.

Weitere Vorteile bestehen im geringeren Filterungsaufwand der Meßsignale, da die Ausgangsrippel bei Meßsignal-Rampen stark verringert sind. Da für die ausgangsseitig am Verstärker durchzuführende Weiterverarbeitung der Meßsignale, insbesondere der Nutzkomponente der Meßsignale, eine geringere Analogbandbreite erforderlich ist, sind die Rauscheigenschaften der Verstärkerschaltung verbessert. Schließlich sind die Aliasing-Fehler bei der beschriebenen Verstärkerschaltung reduziert, da im Hauptsignalpfad keine Sampling-Signalverarbeitung durchgeführt wird.

Die Signalquelle kann ein Magnetfeldsensor sein.

In einer bevorzugten Ausführung der vorliegenden Erfindung sind die Meßsignale in Differenzpfadtechnik geführt. Hierdurch werden Gleichtaktstörungen unterdrückt.

In einer weiteren, vorteilhaften Ausführungsform der vorliegenden Erfindung ist zwischen Magnetfeldsensor und Verstärker ein Modulator angeordnet, der Mittel zum Verpolen der Meßsignal-Leitungen aufweist und am Verstärkerausgang ist ein Demodulator angeordnet, der Mittel zum Verpolen der Meßsigrial-Leitungen aufweist. Die Mittel zum Verpolen der Meßsignal-Leitungen in Modulator und Demodulator können mit einem gemeinsamen Chopping-Takt angesteuert sein.

Falls die Signalquelle ein gechoppt betriebener Hall-Sensor ist, kann die Verstärkerschaltung 90°-Umschalter für Erregerstromanschlüsse und Signalausgänge für die Meßsignale aufweisen, welche im Modulator angeordnet sein können.

Gemäß der vorliegenden Erfindung weist der Fehlersignal-Demodulator ein erstes Tiefpaß-Filter und einen nachgeschalteten Verstärker mit ausgangsseitigem Widerstand auf. Der Verstärker kann ein Transkonduktanzverstärker (OTA, operational transconductance amplifier) sein. Anstelle des Tiefpaß-Filters kann auch ein Summierknoten oder ein Integrator, jeweils mit nachgeschaltetem Verstärker, vorgesehen sein.

Dem Verstärker kann in einer vorteilhaften Ausführungsform ein zweites Tiefpaßfilter nachgeschaltet sein, welches mit analog aufgebauten RC-Gliedern realisiert sein kann. Hierdurch ist es möglich, gemäß dem Prinzip des dynamischen Elementeaustauschs die toleranzbehafteten Widerstände periodisch zu vertauschen, um deren fertigungsbedingte Toleranzen zu kompensieren.

Der Magnetfeldsensor kann ein Hall-Element aufweisen. Wenn die Signalquelle kein Hall-Element ist, müssen die Meßsignale nicht zwingend eine Offsetkomponente aufweisen. In diesem Fall erfolgt dennoch eine Kompensation, nämlich die Kompensation des Offsets des (Chopper-)Verstärkers selbst.

Das Hall-Element kann für einen Chopping-Betrieb zwei orthogonale Klemmenpaare aufweisen, bei denen jeweils an einem Klemmenpaar der Erregerstrom zugeführt und am anderen Klemmenpaar die Hall-Spannung, das heißt das erste oder zweite Meßsignal, abgeleitet werden kann.

Das Fehlersignal kann eingangsseitig oder ausgangsseitig am Verstärker ausgekoppelt werden.

Das erste Tiefpaß-Filter im Fehlersignal-Demodulator kann selbstverständlich durch eine Summierung der Signalspannungen über beide Taktphasen oder eine Mittelwertbildung der Spannungen über beide Taktphasen ersetzt werden. Das erste Tiefpaß-Filter im Fehlersignal-Demodulator kann durch einen Integrator ersetzt werden.

Weitere Einzelheiten der Erfindung sind in den Unteransprüchen angegeben.

Die Erfindung wird nachfolgend an mehreren Ausführungsbeispielen anhand der Zeichnungen näher erläutert.

Es zeigen:
- Figur 1: ein erstes Ausführungsbeispiel der vorliegenden Erfindung in einem Blockschaltbild,
- Figur 2: ein detaillierteres Ausführungsbeispiel gemäß Figur 1 in der ersten Taktphase,
- Figur 3: die Schaltung gemäß Figur 2 in der zweiten Taktphase,
- Figur 4: ein Ausführungsbeispiel der vorliegenden Erfindung mit Auskopplung der Fehlersignale am Verstärkereingang,
- Figur 5: ein Ausführungsbeispiel der Erfindung mit einem zusätzlichen Demodulator im Fehlersignal-Zweig,
- Figur 6: ein Ersatzschaltbild des Hall-Sensors aus Figur 2,
- Figur 7: ein Ersatzschaltbild des Hall-Sensors aus Figur 3, und
- Figur 8: ein Ausführungsbeispiel des zusätzlichen Demodulators aus Figur 5.

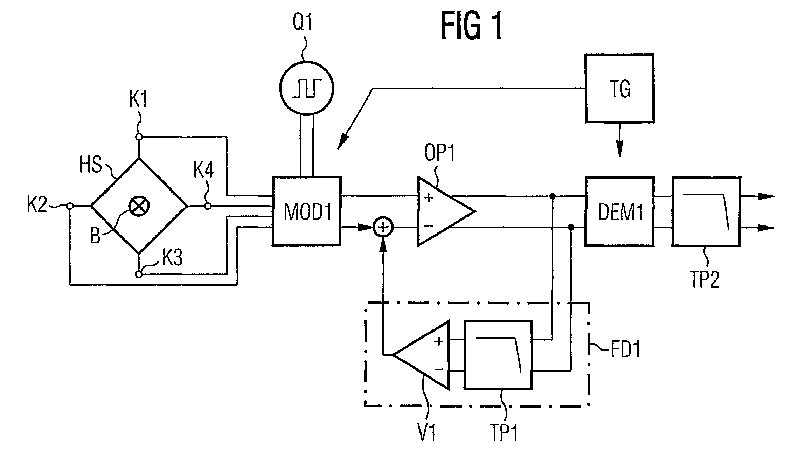

Figur 1 zeigt das vorliegende Prinzip einer Verstärkerschaltung mit Offsetkompensation mit einem Verstärker OP1, der mit seinen Eingängen an einen Hall-Sensor HS angeschlossen ist. Der Hall-Sensor HS ist über ein Modulator MOD1 mit dem Verstärker OP1 sowie einer Stromquelle Q1 zur Zuführung eines Erregerstroms verbunden. Das Hall-Element HS wird von einem Magnetfeld B durchsetzt. Das Hall-Element HS weist vier Klemmen K1 bis K4 auf, von denen jeweils zwei gegenüberliegende mit der Erregerstromquelle Q1 und zwei andere mit den Eingängen des Verstärkers OP1 verbunden sind. Im Nutzsignalpfad ist dem Operationsverstärker OP1 ein erster Demodulator DEM1 nachgeschaltet, welcher Mittel zum Verpolen der in Differenzpfadtechnik ausgeführten Signalleitungen zum Führen der Meßsignale aufweist. Der erste Modulator MOD1 sowie der erste Demodulator DEM1 sind zur Zuführung einer Chopping-Taktfrequenz an einem Taktgenerator TG angeschlossen. Dem ersten Demodulator DEM1 ist ein zweites Tiefpaßfilter TP2 nachgeschaltet, welches der Filterung von durch Umschaltvorgänge bedingten Peaks dient. Ausgangsseitig am Verstärker OP1 ist weiterhin ein Fehlersignal-Demodulator FD1 angeschlossen, der ein erstes Tiefpaß-Filter TP1 mit nachgeschaltetem Verstärker V1 aufweist. Der Verstärkerausgang des Verstärkers V1 ist unter Bildung einer negativen Rückkopplungsschleife an den invertierenden Eingang des Operationsverstärkers OP1 angeschlossen. Der Verstärker V1 ist ein Transkonduktanzverstärker oder ein Spannungsverstärker mit einem ausgangsseitigen Widerstand.

Mit dem Modulator MOD1 ist ein periodisches 90°-Umschalten von Klemmenpaaren des Hall-Sensors HS im Chopping-Takt des Taktgenerators TG realisiert. Die so erzeugten Meßsignale, welche eine Nutzsignalkomponente und eine Offsetkomponente haben, werden in Differenzpfadtechnik dem Operationsverstärker OP1 zugeführt und dort verstärkt. Die Offsetkomponente der Meßsignale wird mit dem ersten Tiefpaßfilter TP1 aus den Meßsignalen ausgekoppelt und verstärkt an den Operationsverstärkereingang gegengekoppelt. Hierdurch ist bereits nach wenigen Taktzyklen die Offsetkomponente der Meßsignale stark reduziert. Folglich kann der Aussteuerbereich des Operationsverstärkers OP1 gegenüber herkömmlichen, gechoppt betriebenen Verstärkern deutlich reduziert sein. Der nachfolgende Filteraufwand kann gering gehalten und Verzögerungszeiten und Rauschen signifikant verringert werden.

Anstelle des ersten Tiefpaß-Filters TP1 können Integrationsglieder, Summationsknoten oder Mittelwertbildner vorgesehen sein.

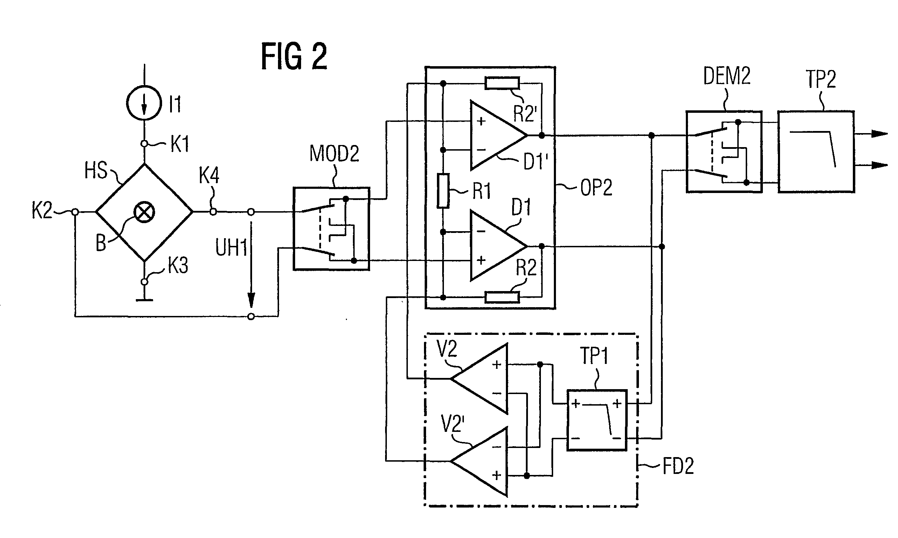

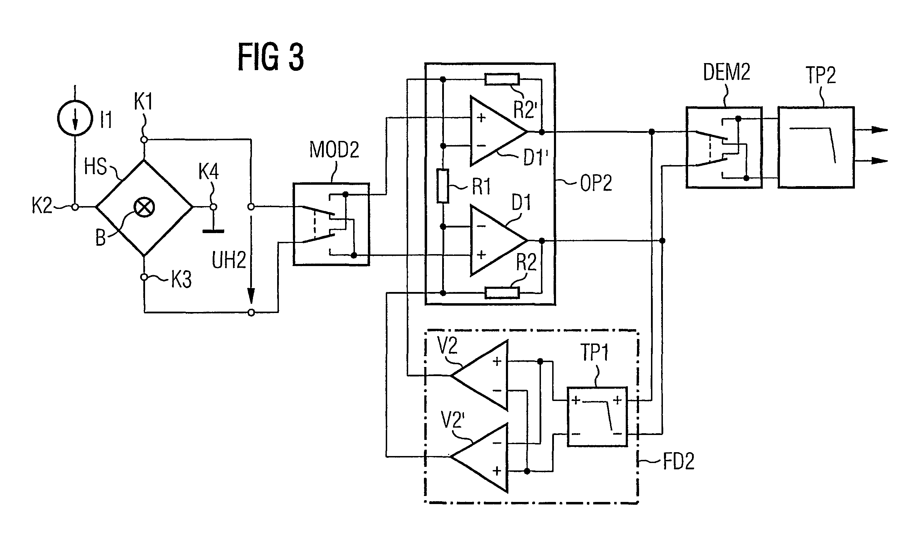

Figur 2 zeigt eine Weiterbildung der Verstärkerschaltung gemäß Figur 1 in der ersten Taktphase, während die Schaltzustände der Schaltung gemäß Figur 2 während der zweiten Taktphase in Figur 3 dargestellt sind.

Der Erregerstrom I1 wird gemäß Figur 2 über die Klemmen K1 und K3 durch den Hall-Sensor geführt. Die Hall-Spannung UH1 während der ersten Taktphase UH1 ist an Klemmen K2 und K4 abgreifbar. Während der ersten Taktphase ist in Modulator MOD2 und Demodulator DEM2 eine verpolungsfreie Durchleitung der Meßsignale gewährleistet. Der Operationsverstärker OP2 gemäß Figur 2 ist als Instrumentationsverstärker ausgeführt. Dieser weist zwei Differenzverstärker D1 und D1' auf, deren nichtinvertierende Eingänge jeweils an die Ausgänge des Modulators MOD2 angeschlossen sind. Die invertierenden Eingänge der Differenzverstärker D1, D1' sind miteinander über einen ersten Widerstand R1 verbunden. Rückkopplungswiderstände R2, R2' verbinden jeweils Differenzverstärkerausgang mit invertierendem Eingang der Differenzverstärker D1, D1'. Der an den Ausgang des Operationsverstärkers OP2 angeschlossene Fehlersignal-Demodulator FD2 weist wiederum ein Tiefpaß-Filter TP1 mit nachgeschalteten Transkonduktanz-Verstärkern V2, V2' auf, deren Ausgänge jeweils an die invertierenden Eingänge der Differenzverstärker D1, D1' angeschlossen sind. In einer alternativen Ausführungsform können die TranskonduktanzVerstärker V2, V2' Spannungsverstärker mit ausgangsseitigem Widerstand sein, oder es kann anstelle der beiden Transkonduktanz-Verstärker V2, V2' ein Transkonduktanzverstärker (OTA) mit zwei Eingängen und zwei Ausgängen (differential in, differential out) vorgesehen sein.

In Figur 3 sind während der zweiten Taktphase die Schalter in Modulator MOD2 und Demodulator DEM2 so geschaltet, daß die in Differenzpfadtechnik geführten Meßsignale jeweils verpolt sind. Außerdem sind Erregerstromzuführung und Hall-SpannungsAbgriff bezüglich Figur 2 am Hall-Sensor HS um 90° gedreht. Dabei erfolgt die 90°-Drehung der Erregerstromzuführung und des Hall-Spannungsabgriffs in entgegengesetzter Drehrichtung.

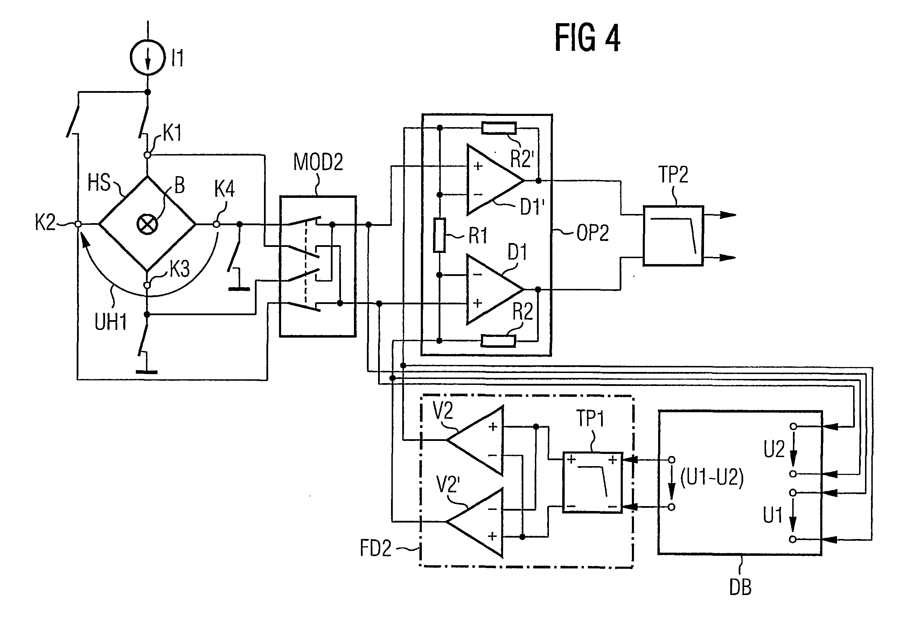

Figur 4 zeigt ein weiteres Ausführungsbeispiel der vorliegenden Erfindung, bei dem die Auskopplung der Offsetkomponenten beziehungsweise der Fehlersignale nicht nach, sondern vor dem Operationsverstärker OP2 erfolgt. In Abweichung vom Ausführungsbeispiel gemäß Figur 2 ist hierbei dem Fehlersignal-Demodulator FD2 ein Differenzbildungs-Baustein DB vorgeschaltet, welcher die Differenz aus der Meßsignal-Differenzspannung U1 und der Differenzspannung über dem Widerstand R1 im Operationsverstärker OP2 bildet. Das Nutzsignal liegt als DC-Signal vor.

Die Schaltungsanordnung gemäß Figur 4 ist während der ersten Taktphase gezeichnet. Die zweite Taktphase ist in Analogie zu Figur 3 in einfacher Weise herleitbar. Erregerstromzuführung und Hallspannungsabgriff werden dabei im gleichen Richtungssinn gedreht. Zum Umschalten von Erregerstromzuführung und Hall-Spannungsabgriff sind vier Schalter vorgesehen, welche an den Knoten K1 bis K4 angeschlossen sind.

Der Differenzbildner DB bildet sowohl in der ersten als auch in der zweiten Taktphase jeweils die Differenz der Differenzspannungen U1, U2. Das nachgeschaltete, erste Tiefpaß-Filter TP1 summiert beziehungsweise integriert die Differenz U1 - U2 der Differenzspannungen U1, U2 jeweils in der ersten und der zweiten Taktphase.

Bei der Schaltung gemäß Figur 4 kann der Demodulator DEM2 entfallen. Die Differenzverstärker D1, D1' gemäß Figur 4 sind als Operationsverstärker ausgelegt, während die Verstärker V2, V2' des Fehlersignal-Demodulators FD2 als Transkonduktanz-Verstärker ausgelegt sind. In einer alternativen Ausführungsform können anstelle der Transkonduktanzverstärker Spannungsverstärker mit ausgangsseitigem Widerstand vorgesehen sein.

Der dem Modulator MOD2 zuführbare Chopping-Takt kann zusätzlich dem ersten Tiefpaß-Filter TP1 zugeführt sein.

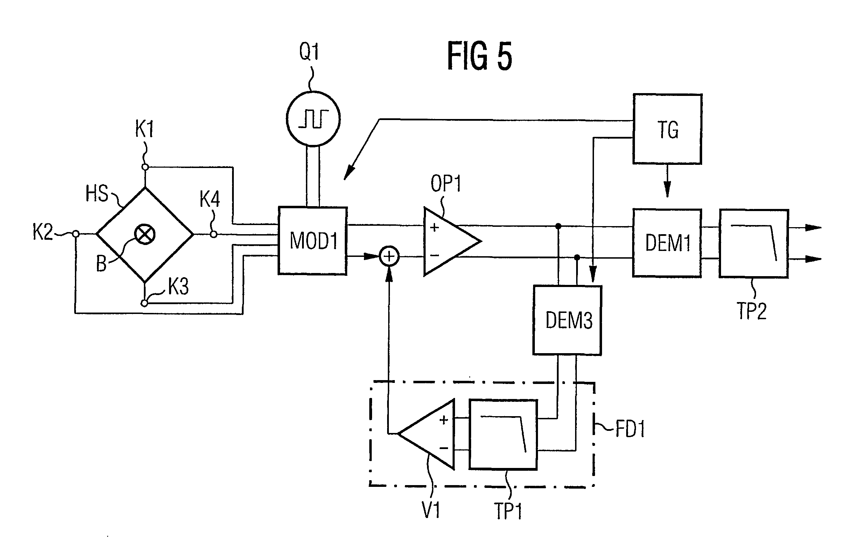

Figur 5 zeigt eine Weiterbildung des Ausführungsbeispiels gemäß Figur 1. Dabei ist ein zusätzlicher Demodulator DEM3 zwischen Ausgang des Verstärkers OP1 und erstem Tiefpaßfilter TP1 angeordnet. Zur Zuführung eines Taktsignals ist der zusätzliche Demodulator DEM3 an den Taktgenerator TG, welcher auch den Modulator MOD1 und den im Nutzsignalpfad angeordneten Demodulator DEM1 ansteuert, angeschlossen. Der zusätzliche Demodulator DEM3 bildet dabei phasenrichtig die Summe oder den Mittelwert über zwei aufeinanderfolgende Taktphasen.

In einer alternativen Ausführungsform zu Figur 5 kann die rückkoppelnde Zuführung der am Fehlersignal-Demodulator ausgangsseitig ableitbaren Signale eingangsseitig am Hall-Element vorgesehen sein. Hierzu können vom Taktgenerator phasenrichtig angesteuerte, zusätzliche Schalter vorgesehen sein. Anstelle des ersten Tiefpaßfilters TP1 können Mittelwertbildner, Summierer oder ein Integrator vorgesehen sein.

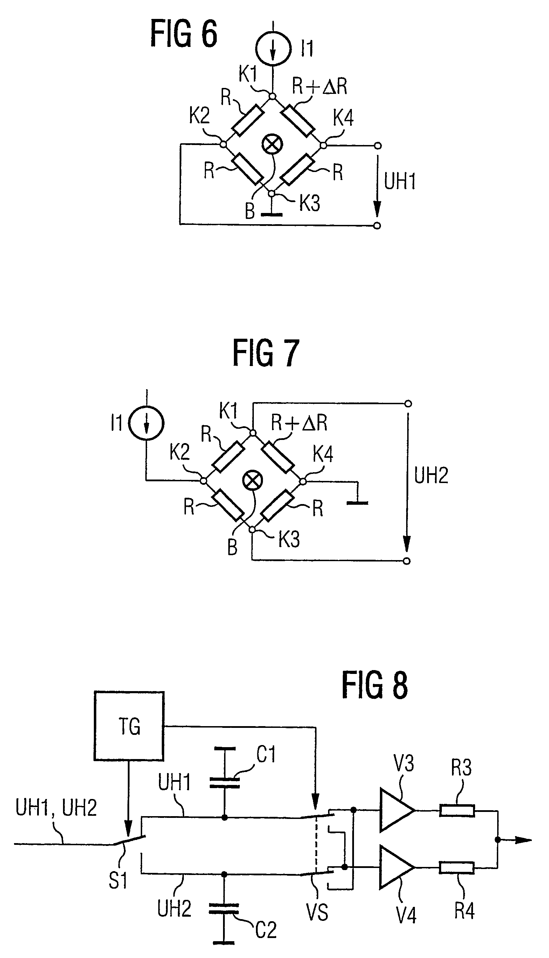

Figur 6 zeigt ein Ersatzschaltbild des Hall-Sensors HS von Figur 2 während der ersten Taktphase. Gemäß dem Ersatzschaltbild nach Figur 6 sind zwischen den vier Klemmen K1 bis K4 des Hall-Sensors jeweils Widerstände R angeordnet, von denen der Widerstand zwischen K1 und K4 eine Abweichung ΔR von den übrigen Widerstandswerten zwischen den benachbarten Klemmen K1 bis K4 hat. Die Abweichung ΔR vom Widerstandswert R des Widerstands zwischen erster und vierter Klemme K1, K4 symbolisiert die Ursache für die richtungsabhängige OffsetSpannung des Hall-Elements. Über ein erstes Klemmenpaar K1, K3 wird der Erregerstrom I1 in das Hall-Element HS eingeprägt. Über dem zweiten Klemmenpaar K2, K4 ist das erste Meßsignal UH1 ableitbar, wenn das Hall-Element von einem Magnetfeld B durchsetzt wird.

Figur 7 zeigt das Ersatzschaltbild gemäß Figur 6 während der zweiten Taktphase und ist demnach ein Ersatzschaltbild für den Hall-Sensor HS gemäß Figur 3. Hierbei sind die Anschlüsse für Erregerstrom und zweites Meßsignal gegenüber Figur 6 um 90° verdreht. Demnach ist über dem ersten Klemmenpaar K1, K3 das zweite Meßsignal UH2 ableitbar, wenn der Erregerstrom I1 über das zweite Klemmenpaar K2, K4 des von einem Magnetfeld B durchsetzten Hall-Elements zugeführt wird.

Gemäß den Ersatzschaltbildern nach Figuren 6 und 7 unterscheiden sich das erste und das zweite Meßsignal dadurch, daß das erste Meßsignal UH1 aus der Summe von Nutzkomponente und Offsetkomponente gebildet ist, während das zweite, während der zweiten Taktphase vorliegende Meßsignal UH2, aus der Differenz von Nutzkomponente und Offsetkomponente gebildet ist.

Figur 8 zeigt ein Blockschaltbild, bei dem ein Verpolungsschalter vorgesehen ist. Die Schaltung gemäß Figur 8 kann in Figur 5 den Demodulator DEM3 ersetzen. Dabei ist zu beachten, daß die Schaltung gemäß Figur 8 in Single-Ended-Technik realisiert ist. Das beschriebene Prinzip läßt sich jedoch auch in Differenzpfadtechnik ausführen.

Bei der Schaltung gemäß Figur 8 ist dem hier nicht gezeichneten Verstärker zur Verstärkung der Meßsignale ein erster Schalter S1 nachgeschaltet, der während der ersten Taktphase das erste Meßsignal UH1 an einen ersten Kondensator C1, und während der zweiten Taktphase das zweite, negative Meßsignal UH2 an einen zweiten Kondensator C2 durchschaltet. Hierzu ist der erste Schalter S1 an einem Taktgenerator TG zur Zuführung eines Chopping-Taktes angeschlossen. Der erste und zweite Kondensator C1, C2 sind jeweils gegen Masse geschaltet. Weiterhin sind erstem und zweitem Kondensator C1, C2 ein Verpolungsschalter VS zum Verpolen der Leitungen für das erste und zweite Meßsignal UH1, UH2 sowie Verstärker, V3, V4 und Widerstände R3, R4 nachgeschaltet, deren ausgangsseitige Anschlüsse miteinander verbunden sind. Der Verpolungsschalter VS wird, ebenso wie der erste Schalter S1, vom Chopping-Takt angesteuert. Die Schaltung gemäß Figur 5 weist den Vorteil auf, daß unumgängliche, fertigungsbedingte Abweichungen der Widerstandswerte der Widerstände R3, R4 voneinander durch das beschriebene, phasengerechte Verpolen der das erste beziehungsweise zweite Meßsignal UH1, UH2 führenden Leitungen kompensiert werden können. Am Ausgang bildet sich somit der Mittelwert des Offsetsignals, der vom Wechselspannungs-Nutzsignal bereinigt ist.

Das beschriebene Prinzip wird als dynamischer Elementeaustausch bezeichnet und vermeidet durch Mismatches bedingte Offsets. Bei der Demodulator-Anordnung gemäß Figur 8 wird der Demodulator zur Fehlerdemodulation durch Rückkopplung eines Fehlersignals verwendet, nicht jedoch zur Demodulation im Signalzweig selbst. Im Signalzweig können Filter angeordnet sein, die offsetfrei sind und folglich keine, durch Änderungen des Nutzsignals bedingten zusätzlichen Fehler verursachen.

Die Erfindung ist auch beim sogenannten Spinning-Hall-Prinzip anwendbar, bei dem nicht nur zwei Klemmenpaare und demnach zwei Taktphasen vorgesehen sind, sondern bei dem das Hall-Element N Klemmenpaare und demnach N Taktphasen aufweist.

Auch bei einem Hall-Element mit nur zwei Klemmenpaaren können vier Taktphasen dadurch gebildet sein, daß der Erregerstrom in 90°-Schritten in das Hall-Element eingespeist und das Meßsignal jeweils orthogonal zum Erregerstrom ableitbar ist.

## Patentansprüche

1. Verstärkerschaltung mit Offsetkompensation, aufweisend
- eine Signalquelle (HS), an der in einer ersten Taktphase ein erstes Meßsignal (UH1) und in einer zweiten Taktphase ein zweites Meßsignal (UH2) ableitbar ist, wobei die Meßsignale (UH1, UH2) jeweils eine Nutzkomponente haben und eine Offsetkomponente aufweisen können,
- einen Verstärker (OP1, OP2), der eingangsseitig an die Signalquelle (HS) zur Zuführung der Meßsignale (UH1, UH2) angeschlossen ist, und an dessen Ausgang die verstärkten Meßsignale bereitstehen,
- einen Fehlersignal-Demodulator (FD1, FD2), der zur Zuführung der Meßsignale (UH1, UH2) an den Eingang oder Ausgang des Verstärkers (OP1, OP2) angeschlossen ist und
- dessen Ausgang an einem Eingang des Verstärkers (OP1) zur Zuführung der Offsetkomponente in einer Gegenkopplung angeschlossen ist,
**dadurch gekennzeichnet, daß** der Fehlersignal-Demodulator (FD1, FD2) ein erstes Tiefpaß-Filter (TP1), einen Integrator, einen Summierer oder einen Mittelwertbildner der Spannungen über beide Taktphasen, und zumindest einen nachgeschalteten Verstärker (V1, V2, V2') aufweist.

2. Verstärkerschaltung nach Anspruch 1,
**dadurch gekennzeichnet, daß**
die Signalquelle (HS) ein Magnetfeldsensor ist.

3. Verstärkerschaltung nach Anspruch 1 oder 2,
**dadurch gekennzeichnet, daß**
die Meßsignale (UH1, UH2) in Differenzpfadtechnik geführt sind.

4. Verstärkerschaltung nach Anspruch 3,
**dadurch gekennzeichnet, daß**
ein Modulator (MOD1, MOD2), der Mittel zum Verpolen der Meßsignal-Leitungen aufweist, zwischen Magnetfeldsensor (HS) und Verstärker (OP1) angeordnet ist, und daß ein Demodulator (DEM1, DEM2) am Verstärkerausgang Mittel zum Verpolen der Meßsignal-Leitungen aufweist.

5. Verstärkerschaltung nach einem der Ansprüche 1 bis 4,
**dadurch gekennzeichnet, daß**
dem Verstärker (OP1, OP2) ein zweites Tiefpaß-Filter (TP2) nachgeschaltet ist.

6. Verstärkerschaltung nach Anspruch 5,
**dadurch gekennzeichnet, daß**
das zweite Tiefpaß-Filter (TP2) mit zumindest einem analog aufgebauten RC-Glied realisiert ist.

7. Verstärkerschaltung nach Anspruch 3 und 6,
**dadurch gekennzeichnet, daß**
das zweite Tiefpaß-Filter (TP2) im Demodulator (DEM2) vorgesehen ist und daß Widerstände dem Mittel zum Verpolen nachgeschaltet sind.

8. Verstärkerschaltung nach einem der Ansprüche 2 bis 7,
**dadurch gekennzeichnet, daß**
der Magnetfeldsensor (HS) ein Hall-Element aufweist.

9. Verstärkerschaltung nach Anspruch 8,
**dadurch gekennzeichnet, daß**
das Hall-Element zwei orthogonale Klemmenpaare (K1, K3; K2, K4) aufweist, wobei in der ersten Taktphase am ersten Klemmenpaar (K1, K3) ein Erregerstrom (I1) zugeführt und am zweiten Klemmenpaar (K2, K4) das erste Meßsignal (UH1) ableitbar ist und in der zweiten Taktphase am zweiten Klemmenpaar (K2, K4) der Erregerstrom (I1) zugeführt und am ersten Klemmenpaar (K1, K3) das zweite Meßsignal (UH2) ableitbar ist.

## Claims

1. Amplifier circuit with offset compensation, comprising
- a signal source (HS), on which a first measured signal (UH1) can be tapped off in a first clock phase and a second measured signal (UH2) can be tapped off in a second clock phase, the measured signals (UH1, UH2) each having a useful component and possibly having an offset component,
- an amplifier (OP1, OP2) which, on the input side, is connected to the signal source (HS) for supplying the measured signals (UH1, UH2) and on whose output the amplified measured signals are provided,
- an error signal demodulator (FD1, FD2), which is connected to the input or output of the amplifier (OP1, OP2) in order to supply the measured signals (UH1, UH2), and
- whose output is coupled to an input of the amplifier (OP1) in antiphase in order to supply the offset component, **characterized in that** the error signal demodulator (FD1, FD2) has a first low-pass filter (TP1), as integrator, a summer or a voltage averager over the two clock phases, and at least one amplifier (V1, V2, V2') connected downstream.

2. Amplifier circuit according to Claim 1, **characterized in that** the signal source (HS) is a magnetic field sensor.

3. Amplifier circuit according to Claim 1 or 2, **characterized in that** the measured signals (UH1, UH2) are carried in the differential path technique.

4. Amplifier circuit according to Claim 3, **characterized in that** a modulator (MOD1, MOD2), which has means of reversing the polarity of the measured signal lines, is arranged between magnetic field sensor (HS) and amplifier (OP1), and **in that** a demodulator (DEM1, DEM2) at the amplifier output has means of reversing the polarity of the measured signal lines.

5. Amplifier circuit according to one of Claims 1 to 4, **characterized in that** a second low-pass filter (TP2) is connected downstream of the amplifier (OP1, OP2).

6. Amplifier circuit according to Claim 5, **characterized in that** the second low-pass filter (TP2) is implemented by at least one RC element constructed in an analogous manner.

7. Amplifier circuit according to Claim 3 and 6, **characterized in that** the second low-pass filter (TP2) is provided in the demodulator (DEM2), and **in that** resistors are connected downstream of the means of reversing polarity.

8. Amplifier circuit according to one of Claims 2 to 7, **characterized in that** the magnetic field sensor (HS) has a Hall element.

9. Amplifier circuit according to Claim 8, **characterized in that** the Hall element has two orthogonal pairs of terminals (K1, K3; K2, K4), an excitation current (I1) being supplied to the first pair of terminals (K1, K3) in the first clock phase, and it being possible for the first measured signal (UH1) to be tapped off at the second pair of terminals (K2, K4), and the excitation current (I1) being supplied to the second pair of terminals (K2, K4) in the second clock phase and it being possible for the second measured signal (UH2) to be tapped off at the first pair of terminals (K1, K3).

## Revendications

1. Circuit amplificateur à compensation du décalage, comprenant
- une source (HS) de signal, de laquelle peut être dérivé, dans une première phase d'horloge, un premier signal (UH1) de mesure et, dans une deuxième phase d'horloge, un deuxième signal (UH2) de mesure, les signaux (UH1, UH2) de mesure pouvant avoir respectivement une composante utile et pouvant présenter une composante de décalage,
- un amplificateur (OP1, OP2) qui est relié du côté entrée à la source (HS) de signal pour l'envoi des signaux (UH1, UH2) de mesure, et à la sortie duquel sont disponibles les signaux de mesure amplifiés,
- un démodulateur (FD1, FD2) de signal d'erreur qui, pour l'envoi des signaux (UH1, UH2) de mesure, est relié à l'entrée ou à la sortie de l'amplificateur (OP1, OP2) et
- dont la sortie est reliée suivant une contre-réaction à une entrée d'amplificateur (OP1) pour l'envoi de la composante de décalage, **caractérisé en ce que** le démodulateur (FD1, FD2) de signal d'erreur comporte un premier filtre (TP1) passe-bas, un intégrateur, un sommateur ou un formateur d'une valeur moyenne des tensions sur les deux phases d'horloge, et au moins un amplificateur (V1, V2, V2') monté en aval.

2. Circuit amplificateur suivant la revendication 1,
**caractérisé en ce que** la source (HS) de signal est un capteur de champ magnétique.

3. Circuit amplificateur suivant la revendication 1 ou 2,
**caractérisé en ce que** les signaux (UH1, UH2) de mesure sont envoyés suivant une technique de trajet différentiel.

4. Circuit amplificateur suivant la revendication 3,
**caractérisé en ce qu'**un modulateur (MOD1, MOD2) ayant des moyens de polarisation des lignes de signal de mesure est monté entre le capteur (HS) de champ magnétique et l'amplificateur (OP1), et **en ce qu'**un démodulateur (DEM1, DEM2) a, à la sortie de l'amplificateur, des moyens de polarisation des lignes de signal de mesure.

5. Circuit amplificateur suivant l'une des revendications 1 à 4,
**caractérisé en ce qu'**un deuxième filtre (TP2) passe-bas est monté en aval de l'amplificateur (OP1, OP2).

6. Circuit amplificateur suivant la revendication 5,
**caractérisé en ce que** le deuxième filtre (TP2) passe-bas est réalisé en ayant au moins un élément RC constitué de façon analogique.

7. Circuit amplificateur suivant la revendication 3 et 6,
**caractérisé en ce que** le deuxième filtre (TP2) passe-bas est prévu dans le démodulateur (DEM2) et **en ce que** des résistances sont montées en aval des moyens de polarisation.

8. Circuit amplificateur suivant l'une des revendications 2 à 7,
**caractérisé en ce que** le capteur (HS) de champ magnétique est un élément Hall.

9. Circuit amplificateur suivant la revendication 8,
**caractérisé en ce que** l'élément Hall a deux paires (K1, K3 ; K2, K4) de bornes orthogonales, telles que dans la première phase d'horloge, un courant (I1) d'excitation est envoyé à la première paire (K1, K3) de bornes et le premier signal (UH1) de mesure peut être prélevé de la deuxième paire (K2, K4) de bornes, et dans la deuxième phase d'horloge, le courant (I1) d'excitation est envoyé à la deuxième paire (K2, K4) de bornes et le deuxième signal (UH2) de mesure peut être prélevé de la première paire (K1, K3) de bornes.
